# EUROPEAN PATENT SPECIFICATION

(11) **EP 3 168 071 B1**
(45) Date of publication and mention of the grant of the patent: **26.12.2018**
(21) Application number: 16173604.6
(22) Date of filing: 08.06.2016
(51) Int. Cl.: B60G 21/05, B60B 35/04, B60B 35/08, F16F 1/14, G06F 17/50

(54) **A CROSSMEMBER OF A TORSION BAR REAR SUSPENSION FOR A MOTOR VEHICLE, AND PROCESS FOR DESIGNING SUCH CROSS MEMBER**
QUERTRÄGER EINER TORSIONSSTABHINTERRADAUFHÄNGUNG FÜR EIN KRAFTFAHRZEUG UND VERFAHREN ZUR KONSTRUKTION SOLCH EINES QUERTRÄGERS
TRAVERSE DE BARRE DE TORSION D'UNE SUSPENSION ARRIÈRE POUR UN VÉHICULE AUTOMOBILE ET PROCÉDÉ DE CONCEPTION D'UNE TELLE TRAVERSE

(30) Priority: 08.06.2015 IT UB20151216
(43) Date of publication of application: 17.05.2017
(73) Proprietor: FCA Italy S.p.A., 10135 Torino (IT)
(72) Inventor: MESSINA, Alessandro, 10135 TORINO (IT); TAURINO, Andrea, 10135 TORINO (IT); PAVESIO, Carlo, 10135 TORINO (IT)
(74) Representative: Lovino, Paolo

(56) References cited:
- WO-A1-2005/044603
- DE-A1- 19 533 479
- JP-A- 2000 158 928
- JP-A- 2012 131 316

## Description

The present invention relates to a cross member of a torsion bar rear suspension for a vehicle. This type of suspension is also commonly referred to as a twist-beam rear suspension.

As it is known, a twist-beam rear suspension comprises a pair of longitudinal arms. Each of them carries a relative wheel, is swinging relative to the body and is coupled to this latter by interposing respective springs and shock absorbers. The two longitudinal arms are connected by a beam or cross member, which links the wheels but is elastically flexible in torsion.

Several predefined performance requirements, relating for instance to torsional rigidity, flexural rigidities, fatigue duration and strength, position of the shear centre, etc. must be met for the design of torsion bars. Besides meeting such operating requirements, during the design phase the weight of the suspension as a whole, and therefore that of the cross member, must be minimized as much as possible.

However, the known solutions do not always find an optimal compromise in the design of the cross member. In particular, the geometrical parameters of the known solutions cannot be modified by the designer to selectively meet the different operating requirements, to obtain desired target values for each requirement and, at the same time, to minimize the weight of the cross member.

For example, in a first known embodiment, the twist-beam of the suspension is made from a tube having a central portion, which is pressed in the radial direction to obtain substantially a double wall, with a substantially U-shaped cross section, while the cross section at the longitudinal ends of the cross remains tubular.

In this solution, the thickness of the starting tube wall may be varied as a design parameter to obtain the required conditions. However, if the thickness is too small, it affects the duration of the cross member, and the desired duration cannot be restored by adjusting other parameters; in fact, the desired duration would be restored by redefining the diameter of the starting tube, with a consequent increase of weight and cost and a consequent performance variation.

In a second known embodiment, the cross member includes a profile having an open, substantially U-shaped cross section, and at least two reinforcing or stiffening elements, referred to as "partitions", welded at the longitudinal ends of the profile, at the areas where the cross member must be fixed to the suspension arms.

Even this solution is scarcely satisfactory, since it is relatively heavy and has unwanted weldings, which may trigger a breakage in their surroundings. Moreover, the weldings are relatively difficult to carry out, given the complex shape of the perimeter of the partitions.

In a third known embodiment, the twist-beam has a closed circular cross section at its longitudinal ends, and has an open cross section at its own central part. In other words, the cross member is actually defined by a tube with a substantially circular cross section, having a longitudinal slit or slot.

This solution avoids the problems of the previous solution, due to the welded "partitions", but generally fails to lighten the cross member.

Furthermore, in this case, the parameters that can be adjusted in the design phase are defined by the thickness of the cross member and by the size of the slit: these parameters are not sufficient to obtain an optimum compromise, in particular as regards the values of the flexural rigidities.

The solution shown in Figure 3 of DE19533479A1 corresponds to the preamble of claim 1 and defines an evolution of the aforesaid solution. The longitudinal slit is defined by two wings that protrude inside the cross member. Thanks to these wings, the flexural rigidities of the cross member can be increased.

However, even this solution has drawbacks. First, the wings are distinct and are obtained by bending inwardly the wall of a circular tube, so that each wing projects to a height, which is fixed, and well defined, corresponding to half the length of the slit (measured substantially along the circumference of the tube). This dimensional constraint limits the optimization of the design parameters of the cross member, not only as regards the protruding height of the wings, but also as regards the distance between the upper edge of the cross member and the axis of the cross member.

Furthermore, the profile of the ends of the cross member is explicitly described as having a circular shape to facilitate coupling and further processes. This shape gives obvious geometric constraints, thus limiting the chance of finding an optimum compromise for the design requirements. In fact, there is no suggestion to use, in the design phase, one or more geometric parameters, identifiable in the cross sections and/or in the longitudinal sections of the cross member, and to optimize them one with respect to the other through a suitable process to obtain the desired target values for the various operating requirements.

In particular, this prior art document does not suggest how a design could find a compromise between the various requirements to be met and actually get an optimal solution and a reduction in weight.

Moreover, at the longitudinal ends of the slit, the tube can be subject to defects because of fatigue stresses, given the shape of the edge of the slit next to the areas of highest stress (where the cross member is fixed to the oscillating arms of the suspension).

The object of the present invention is to provide a cross member of a torsion bar rear suspension for a motor vehicle, which allows to solve in a simple and economical manner the aforesaid problems.

The present invention provides a cross member of a torsion bar rear suspension for a motor vehicle as defined in claim 1.

The invention will now be described with reference to the accompanying drawings, which illustrate a non-limiting embodiment, in which:
- Figure 1 is a partial perspective view of a torsion bar rear suspension for a motor vehicle, provided with a preferred embodiment of the cross member according to the present invention;
- Figure 2 is a bottom perspective view of the cross member of Figure 1;

- Figure 3 is a section of the cross member, in enlarged scale, according to the section plane identified by the line III-III of Figure 2;
- Figure 4 is a cross section of the cross member, on a further enlarged scale, according to a vertical centreline section plane, identified by the line IV-IV of Figure 3;
- Figure 5 is a side view of the cross member of the preceding figures;
- Figure 6 is similar to Figure 3 and shows a variant of the cross member of Figure 3; and

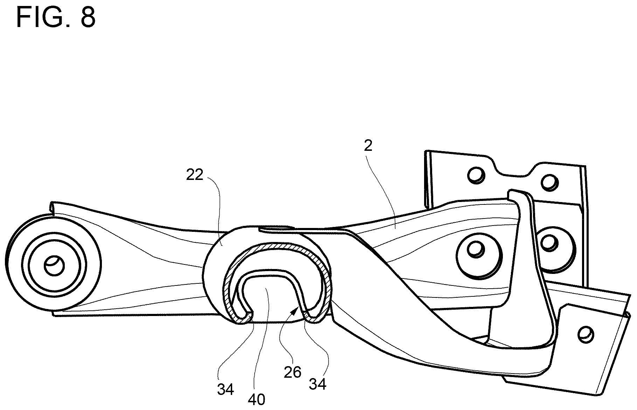

- Figures 7 and 8 are perspective views of one end of the cross members of Figures 3 and 6, respectively;
- Figure 9 shows a flat metal sheet, defining a blank from which the cross member of the present invention is manufactured.

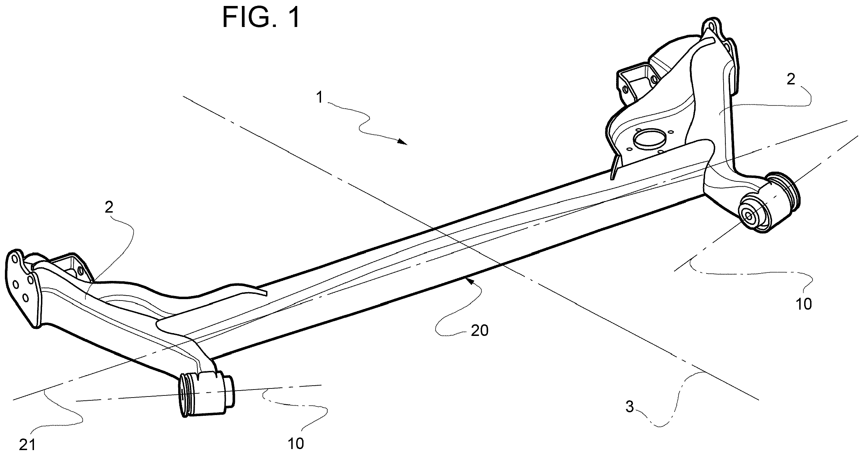

In Figure 1, the reference number 1 indicates, as a whole, a torsion bar rear suspension (partially shown) for a motor vehicle (not shown). The suspension 1, of the type indicated as twist beam rear suspension, comprises a pair of oscillating arms 2, which extend substantially in directions parallel to a travel direction 3 of the motor vehicle.

The oscillating arms 2 are hinged, in a known and not shown manner, to the motor vehicle body to rotate about respective axes 10, which are transverse to the direction 3 and are symmetrical to each other. Moreover, the oscillating arms 2 are coupled to the body by interposing respective dampers (not shown) and respective springs (not shown).

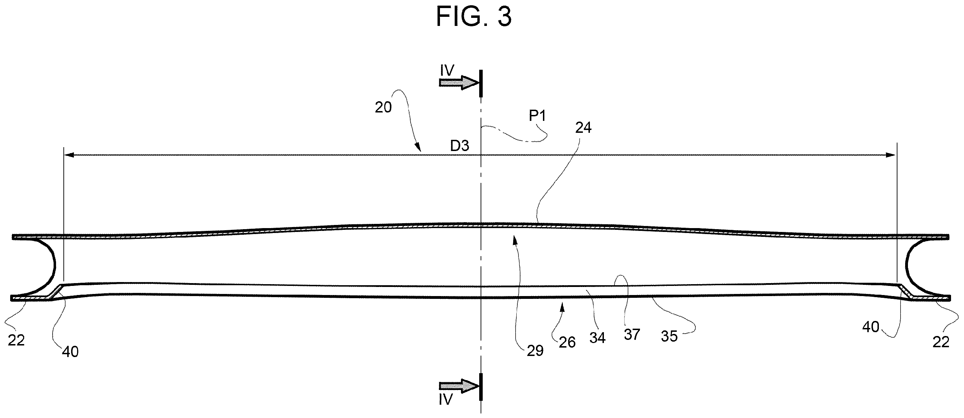

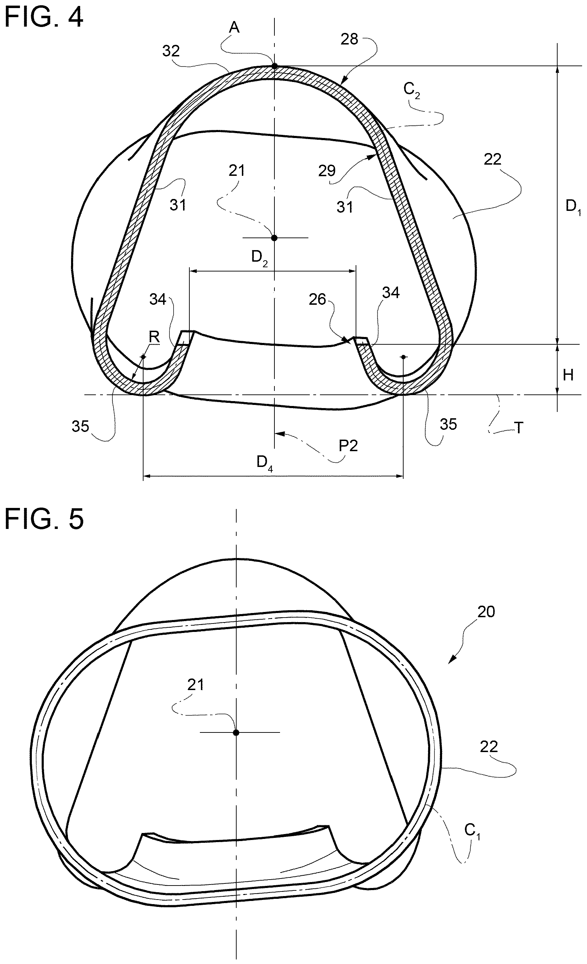

The suspension 1 further comprises a beam or cross member 20, which connects the oscillating arms 2 and extends along a longitudinal axis 21, orthogonal to the direction 3. The cross member 20 is symmetrical with respect to a vertical centreline plane P1 (Fig. 3), which is orthogonal to the axis 21 and coincides with the section plane of Figure 4. The cross member 20 is obtained by a manufacturing process, which is not described in detail and can be selected among various available technologies, so as to obtain dimensional values that are associated with certain geometric parameters and that have been designed to meet certain requirements (strength, stiffness, durability, inertia, etc.).

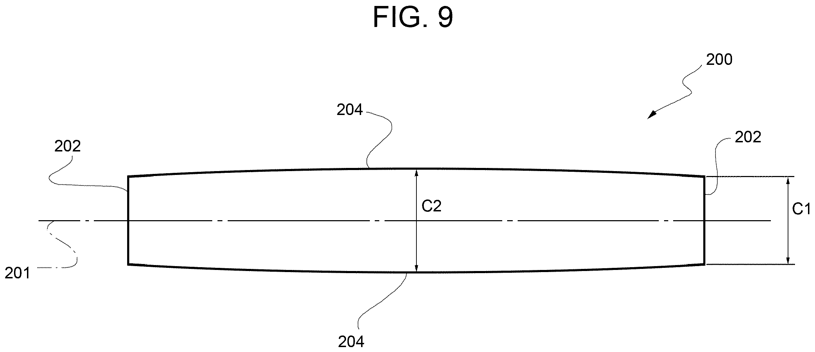

Advantageously, in this process, the cross member 20 is manufactured starting from a blank defined by a flat metal sheet 200 (Fig. 9), which is plastically deformed. The metal sheet 200 extends along a longitudinal rectilinear axis 201 and, in the direction orthogonal to the axis 201, has a centreline height greater than the height of the two opposite longitudinal ends 202. As shown in Figure 9, the metal sheet 200 has two edges 204, which are arranged on opposite sides of the axis 201: advantageously, at least one of the edges 204 is curved convex, to obtain in a relatively simple manner the aforesaid height dimensioning. The cross member 20 is defined by a single shaped plate, which preferably has a constant thickness throughout its extension. This thickness defines the parameter S.

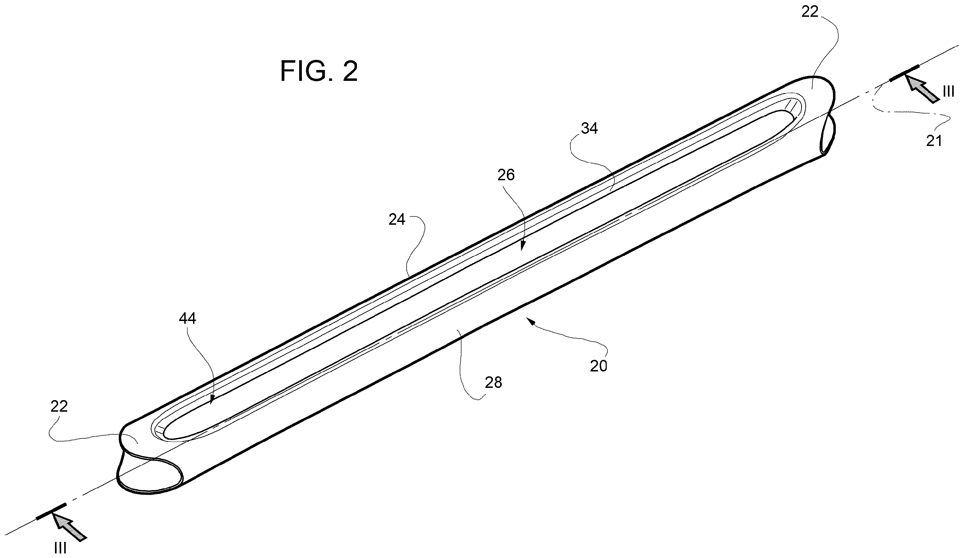

As shown in Figure 2, the cross member 20 longitudinally ends with two opposite tubular portions 22, respectively obtained by the plastic deformation of the ends 202. The cross section of the portions 22 has no particular limitations with regard to their shape (circular, oval, triangular, irregular, etc.).

The portions 22 are fixed in a known manner, not described in detail, to the oscillating arms 2. The length of the development of the lateral profile of the portions 22 (considering such lateral profile from a view along the axis 21, as in Fig. 5) defines the parameter C1. With reference to Figure 9, the parameter C1 corresponds to the height of the ends 202 in the direction orthogonal to the axis 201.

The cross member 20 is formed by the two portions 22 and by a central portion 24, which has an open cross section with respect to any section plane orthogonal to the axis 21, since at the portion 24 the cross member 20 has a slot or slit 26, which is elongated in a longitudinal direction parallel to the axis 21.

As shown in Figure 4, the parameter C2 defines the length of the development of the cross section of the portion 24 at the section plane P1 (the parameters C1 and C2 are also called "chords", in the technical field of suspensions). With reference to Figure 9, the parameter C2 corresponds to the height of the metal sheet 200, i.e. to the distance between the edges 204, in a direction orthogonal to the axis 201 and at the middle of the metal sheet 200.

The portion 24 comprises a wall 28 that is shaped to join the portions 22 in the longitudinal direction and has a substantially U-shaped cross section. In other words, the wall 28 defines an axial cavity 29, open radially to the outside through the slit 26. Preferably, in the centreline cross section, i.e. at the plane P1 (Fig. 4), the wall 28 has a substantially inverted V-shape with rounded vertex, namely it comprises two sides 31, substantially rectilinear and converging towards each other, and a curved portion 32 which connects the sides 31 and has an apex whose position defines the parameter A.

The shape of the cross section of the wall 28 progressively varies in the longitudinal direction to connect the tubular profile of the portions 22 to the substantially V-shaped centreline cross section.

Preferably, the wall 28 is symmetrical with respect to a centreline plane P2 (coinciding with the section plane of Figure 3), on which the axis 21 lies. However, according to variations not shown, the shape of the cross section of the wall 28 may differ. For example, the sides 31 might be curved toward the inside or toward the outside of the cavity 29; and/or the apex of the curved portion 32 might be spaced from the plane P2 to define a designed asymmetry, e.g. to optimize the position of the shear centre of the cross member 20.

The portion 24 further comprises two wings 34 that protrude into the cavity 29, without contacting the surface of the cavity 29. The wings 34 are connected to the ends of the wall 28 by means of respective curved portions 35. Preferably, the curved portions 35 have the same shape and are symmetrical with respect to the plane P2, so that for each cross section of the portion 24, the radius of curvature or bending of the curved portions 35 is the same. Usually, said radius progressively varies by varying the position of the cross section along the slit 26.

The wings 34 terminate with respective edges 37, which engage the cavity and, as mentioned above, are spaced from each other and from the inner surface of the wall 28. Considering any one of the cross sections of the portion 24 (e.g. the one of Figure 4):
- the distance between the two edges 37, in the tangential direction with respect to the axis 21, defines the parameter D2;
- the distance between the apex of the curved portion 32 and the edges 37 along the plane P2 defines the parameter D1;
- the radius of curvature or bending of the curved portions defines the parameter R;
- the distance between the centres of curvature or bending of the curved portions 35 defines the parameter D4;
- the parameter H defines the height of the wings 34, measured between the edges 37 and a reference line T that is tangent to the curved portions 35.

Preferably, as mentioned above, the wings 34 and the curved portions 35 are symmetrical with respect to the plane P2: in this case, in each of the cross sections of the portion 24, the line T is orthogonal to the plane P2 and the value of the parameter H is equal between the two wings 34. More generally, the parameter H might assume different values for the two wings 34 if they were not perfectly symmetrical with respect to the plane P2.

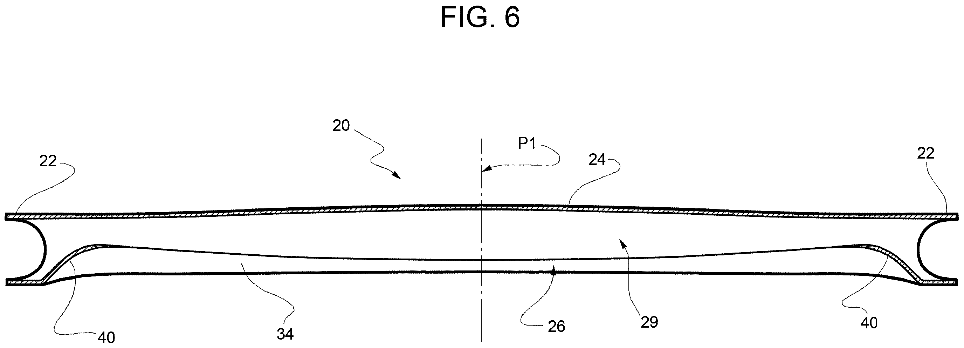

The value of the parameter D2 substantially corresponds to the width of the slit 26 and, in general, varies by varying the longitudinal position of the section plane along the axis 21: it is maximum at the plane P1, it can possibly remain constant in the central part of the portion 24, and it decreases in a progressive manner (i.e. without steps or abrupt changes) unto the longitudinal ends of the slit 26. Even the value of the parameter H varies by varying the position of the cross section along the slit 26. In the solution of Figure 3, the value of the parameter H is approximately constant by moving longitudinally along the slit 26. On the other hand, in the variant of Figure 6, the values of the parameter H at the longitudinal ends are greater than the one at the plane P1.

The value of the parameter H is set to optimize the torsional rigidity value without substantially altering the weight of the cross member 20.

Specifically, the designed value of the parameter H is adjusted independently of each of the remaining geometric parameters, in particular independently of the parameter D2.

Analogously, also the structural characteristics and/or the manufacturing process of the cross member 20 must be configured so as to obtain a value of the parameter H independent of each of the values of the other geometric parameters, in particular D2.

Furthermore, according to the present invention, the value of the chord C2 (at the plane P1 of Fig. 4) is higher than the value of the chord C1, as better explained in the following.

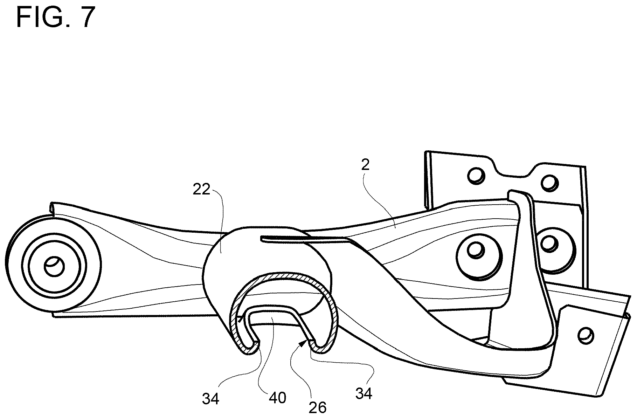

According to a further aspect of the present invention, as shown in the Figure 3 and 7, at the longitudinal ends of the slit 26, the two wings 34 are joined together by connecting walls 40, also defining a bending with respect to the portions 22. In particular, the parameter D3 defines the width of the longitudinal slit 26, i.e. the distance in the plane P2 between the connecting walls 40.

It is therefore evident that the slit 26 is defined by a folded flap 42 (Fig. 2), which protrudes toward the inside of the cavity 29 and is continuous around the perimeter of the slit 26. In other words, the folded flap 42 is made of the two wings 34 (facing each other in the tangential direction) and of the two connecting walls 40 (facing each other in the longitudinal direction).

The designed shape and size of the portions 22 are essentially determined by the interface between the cross member 20 and the oscillating arms 2 and by the available spaces. However, within certain limits, the value of the parameter C1 and the profile shape of the portions 22 can be defined and optimized depending on the required characteristics (for example, the profile may be ovalized for structural reasons in the area of junction to the arms 2; or it may be rounded because of the forming process; or it may be made sharper to increase the torsional rigidity and/or the length coupled to the arms 2, etc.).

At the same time, the value of the parameter C2 is provisionally and hypothetically assumed equal to the one of the parameter C1.

Moreover, also the values for the parameters R and D4 are selected.

Once made these initial choices, the volume and, therefore, the weight of the cross member 20 are substantially defined, because they depend almost exclusively on the value of the parameter S. In fact, a variation in the remaining parameters (H, D1, D2, D3, A) does not substantially change the amount of material necessary to define the sections of the cross member 20, and therefore does not remarkably change the weight of this latter (the parameter with the greatest influence on weight is D3).

The parameters S, H, D1, D2, D3 and A are initially set with provisional values, in particular to oversize the cross member 20 with respect to target values that are required for the various operating conditions, defined by: torsional rigidity and flexural rigidities (even in localized areas), fatigue duration, position of the shear/roll centre, etc.

To find an optimal compromise meeting these operating requirements, the values of the parameters R and D4 are left unaltered, while at least some of the parameters H, D1, D2, D3, A are varied.

In this way, the designed torsional rigidity, flexural rigidities, shear centre, etc. may be adjusted without substantially altering the weight of the cross member. These parameters (H, D1, D2, D3, A) are changed individually or simultaneously, possibly through successive attempts, in order to approximate to the target values for the operating requirements without falling below these target values. In particular:
- by varying the parameter D1 and the parameter A (and therefore varying the shape of the wall 28), the position of the shear/roll centre can be optimized;
- by varying the parameters H and D2, the torsional rigidity of the cross member (although affecting the flexural rigidities) can be optimized; in particular, the torsional rigidity decreases by increasing the parameter D2 and by decreasing the parameter H;
- by varying the parameter D3, the torsional rigidity can be slightly optimized without influencing the flexural rigidities at the centreline.

In particular, the parameters H and D2 should be suitably adjusted to approximate to the target value of torsional rigidity.

In any one of the cross sections, by varying the values of the parameters H and D2 and by maintaining the values of the parameters R and D4, also the angle of curvature, i.e. the angular extent, of the curved portions 35 can be freely changed.

With particular reference to Figure 4, in the cross section of the centreline, i.e. at the plane P1, the curved portions 35 define a bending or curvature substantially equal to 180° with respect to the sides 31 (the term "substantially" in this case means that the curvature or bending is comprised between 160° and 200°).

Substantially, the above parameters are optimized to obtain the best compromise according to the design requirements, but remain independent. In particular, this solution does not require to vary a second parameter as a consequence of the variation of a first parameter (for example, by varying D2, the parameters H, C1, R4, D1, D3, D4, A, etc. must not necessarily/compulsorily change). This condition of independence among the geometric parameters of the cross member, however, cannot be found in the prior art (e.g. in the solution described in the document DE19533479A1, the parameters H and D2 are mutually dependent and bi-univocally correlated).

After having approximated to the target values without ever falling below them, it is assumed a reduction of the provisional value initially set for the parameter S to further reduce the torsional rigidity, until defining a limit thickness value, which allows obtaining the desired torsional rigidity.

Now, it is extremely likely that, with the defined limit thickness value, the flexural rigidities at the centreline (plane P1) become lower than their target values. The value of the parameter C2 is incremented to obviate this drawback, and then restore the target values of the flexural rigidities.

This increase in the value of the parameter C2 leads to a slight increase in weight and to a further slight increase in torsional rigidity. This increase is insignificant: in fact, with the open sections, the torsional rigidity increases linearly in response to an increase of the chord C2, and not in a quadratic manner as it would be the case for the closed cross sections.

This is a good compromise for the size of the cross member 20 and the minimum possible thickness for the wall of the cross member 20. However, successive refinements are possible.

From the aforesaid, it is clear that the designer is quite free to define the best compromise during the design phase. In particular, setting the parameter C2 to a value greater than the one of the parameter C1, besides improving the flexural rigidities, makes mutually independent the position of the axis 21 and the position of the upper end edges and of the lower end edges of the cross member 20. For example, in the known solutions, the distance between the upper edge of the cross member and the axis 21 is necessarily smaller than half of the value of the parameter C1, while the proposed solution leaves some freedom in the designed setting of the position of the axis 21.

In particular, thanks to this freedom in the design, an axis 21 may even be not straight but curved, and therefore completely independent of the shape of the various cross sections of the cross member 20 along the axis 21.

In the design process, the designer can scale the value of the parameter H to adjust the value of torsional rigidity and approximate it to its target value. The designer has great freedom, since the value of the parameter H may be varied regardless of the value of the parameters C1, C2 and D2.

In particular, the parameter H may be adjusted substantially at will, since the configuration of the cross member 20 does not require its compulsory variation depending on other parameters. The same applies to the chord C2, which is set to a value greater than the one of the chord C1 in order to increase the flexural rigidities at the centreline of the cross section.

Moreover, thanks to the configuration and to the geometric shape of the cross member 20, the designer has the freedom to vary several parameters, some of which only unremarkably affect the weight of the cross member 20.

In particular, the proposed design process maintains unchanged the values of the parameters C1, R and D4 during the adjustment of the other parameters, so as to reach in a relatively simple and fast way the best design compromise. In fact, the torsional rigidity or the flexural rigidities or the weight may be selectively adjusted without thereby altering the other design requirements. In other words, the various operating requirements may be selectively adjusted, almost independently of one another, to obtain the corresponding target values.

Thanks to the optimization achieved through to the cross member 20 of the present invention, it is possible to reduce the thickness, and therefore the weight of the cross member 20, up to a limit value that is significantly lower than the one of the known solutions, while still meeting the other operating requirements. In particular, computer simulations have shown that it is possible to achieve a weight reduction of about 40% compared with the known solutions.

Furthermore, also the required duration can be obtained thanks to the configuration and the shape of the cross member 20. In particular, the fact of making a single folded flap 42 by joining the wings 34 through the connecting walls 40 at the longitudinal ends of the slit 26 substantially reduces the breaking risks at these ends. From the aforesaid it is finally clear that the cross member 20 which has been described with reference to the attached figures may be subject to modifications and variants which do not depart from the scope of protection of the present invention, as defined in the appended claims.

In particular, the cross member 20 might be constituted by a plate or wall of the multi-layer type and/or having a variable thickness.

## Claims

1. A cross member of a torsion bar rear suspension for a motor vehicle; the cross member (20) extending along a longitudinal axis (21) and comprising:
- two tubular portions (22) arranged at the opposite longitudinal ends of the cross member (20);
- a central portion (24) having a longitudinal slit (26) so as to have an open cross section, considering any section plane orthogonal to said longitudinal axis (21); said central portion (24) comprising:
a) a wall (28) that joins said tubular portions (22) to each other in longitudinal direction and defines an axial cavity (29), open radially towards the outside through said longitudinal slit (26) ;
b) two wings (34), which define said longitudinal slit (26), are joined to said wall (28) through respective curved portions (35), project into said cavity (29) and end with respective edges (37) spaced from one another and from said wall (28);
the cross member consisting of a single plate, symmetrical with respect to a centreline section plane (P1), orthogonal to said longitudinal axis (21), and being **characterized in that** the length of the development of the cross section at said centreline section plane (P1) is greater than the length of the development of the lateral profile of said tubular portions (22).

2. A cross member according to claim 1, **characterised in that** said wings (34) are parts of a single folded flap (42), which defines said slit (26), projects towards the inside of said cavity (29) and is continuous along the perimeter of said slit (26).

3. A cross member according to claim 1 or 2, **characterised in that**, at said centreline section plane (P1), said curved portions (35) define a bend or curvature substantially equal to 180°.

4. A cross member according any one of the preceding claims, **characterised in that** said wings (34) and said curved portions (35) are symmetrical with respect to a centreline plane (P2) on which said longitudinal axis (21) lies.

## Patentansprüche

1. Querträger einer hinteren Drehstabfederung für ein Kraftfahrzeug; wobei der Querträger (20) sich entlang einer Längsachse (21) erstreckt und Folgendes umfasst:
- zwei rohrförmige Abschnitte (22), die an den entgegengesetzten längslaufenden Enden des Querträgers (20) angeordnet sind;
- einen mittleren Abschnitt (24), der einen länglichen Schlitz (26) aufweist, um so einen offenen Querschnitt aufzuweisen, in Anbetracht jeglicher Schnittebene, die orthogonal zur Längsachse (21) ist; wobei der mittlere Abschnitt (24) umfasst:
a) eine Wand (28), die die rohrförmigen Abschnitte (22) in einer Längsrichtung miteinander verbindet und einen axialen Hohlraum (29) definiert, der sich durch den länglichen Schlitz (26) radial nach außen öffnet;
b) zwei Flügel (34), welche den länglichen Schlitz (26) definieren, sind mit der Wand (28) durch jeweilige gekrümmte Abschnitte (35) verbunden, welche in den Hohlraum (29) ragen und mit jeweiligen Kanten (37), die voneinander und von der Wand (28) beabstandet sind, abschließen;
wobei der Querträger aus einem einzelnen Blech besteht, das bezüglich einer Mittellinien-Schnittebene (P1) symmetrisch ist, welche orthogonal zur Längsachse (21) ist, und **dadurch gekennzeichnet ist, dass** die Länge des Aufbaus des Querschnitts an der Mittellinien-Schnittebene (P1) größer ist als die Länge des Aufbaus des lateralen Profils der rohrförmigen Abschnitte (22).

2. Querträger nach Anspruch 1, **dadurch gekennzeichnet, dass** die Flügel (34) Teile einer einzelnen gefalzten Klappe (42) sind, welche den Schlitz (26) definiert, nach innen in den Hohlraum (29) ragt und entlang des Umfangs des Schlitzes (26) fortläuft.

3. Querträger nach Anspruch 1 oder 2, **dadurch gekennzeichnet, dass** die gekrümmten Abschnitte (35) an der Mittellinien-Schnittebene (P1) eine Biegung oder Krümmung, die im Wesentlichen gleich 180° ist, definieren.

4. Querträger nach einem der vorhergehenden Ansprüche, **dadurch gekennzeichnet, dass** die Flügel (34) und die gekrümmten Abschnitte (35) bezüglich einer Mittellinienebene (P2), auf welcher die Längsachse (21) liegt, symmetrisch sind.

## Revendications

1. Traverse d'une suspension arrière à barre de torsion pour un véhicule à moteur ; la traverse (20) s'étendant le long d'un axe longitudinal (21) et comprenant :
deux parties tubulaires (22) agencées au niveau des extrémités longitudinales opposées de la traverse (20) ;
une partie centrale (24) ayant une fente longitudinale (26) pour avoir une section transversale ouverte, en prenant en considération n'importe quel plan transversal orthogonal audit axe longitudinal (21) ; ladite partie centrale (24) comprenant :
a) une paroi (28) qui assemble lesdites parties tubulaires (22) entre elles dans la direction longitudinale et définit une cavité axiale (29), ouverte radialement vers l'extérieur en passant par ladite fente longitudinale (26) ;
b) deux ailes (34) qui définissent ladite fente longitudinale (26), sont assemblées à ladite paroi (28) par des parties incurvées (35) respectives, font saillie dans ladite cavité (29) et se terminent par des bords (37) respectifs espacés les uns des autres et de ladite paroi (28) ;
la traverse se composant d'une seule plaque, symétrique par rapport à un plan transversal central (P1) orthogonal audit axe longitudinal (21) et étant **caractérisée en ce que** la longueur du développement de la section transversale au niveau dudit plan transversal central (P1) est supérieure à la longueur du développement du profil latéral desdites parties tubulaires (22).

2. Traverse selon la revendication 1, **caractérisée en ce que** lesdits ailes (34) sont des parties d'un rabat (42) plié unique, qui définit ladite fente (26), fait saillie vers l'intérieur de ladite cavité (29) et est continu le long du périmètre de ladite fente (26).

3. Traverse selon la revendication 1 ou 2, **caractérisée en ce que**, au niveau dudit plan transversal central (P1), lesdites parties incurvées (35) définissent un pli ou une courbure sensiblement égal(e) à 180°.

4. Traverse selon l'une quelconque des revendications précédentes, **caractérisée en ce que** lesdites ailes (34) et lesdites parties incurvées (35) sont symétriques par rapport à un plan central (P2) sur lequel ledit axe longitudinal (21) se trouve.
